# EUROPÄISCHE PATENTSCHRIFT

(11) **EP 3 365 908 B1**
(45) Veröffentlichungstag und Bekanntmachung des Hinweises auf die Patenterteilung: **11.08.2021**
(21) Anmeldenummer: 16781696.6
(22) Anmeldetag: 29.09.2016
(51) Int. Cl.: H01H 35/24, G01L 19/04, G01L 27/00, H01H 35/28, A62C 3/08

(54) **VERFAHREN UND VORRICHTUNG ZUM TESTEN EINES TEMPERATURKOMPENSIERTEN, DRUCKGRADIENTGESTEUERTEN DRUCKSCHALTERS**
METHOD AND DEVICE FOR TESTING A TEMPERATURE-COMPENSATED, PRESSURE-GRADIENT-CONTROLLED PRESSURE SWITCH
PROCÉDÉ ET DISPOSITIF POUR TESTER UN PRESSOSTAT COMPENSÉ EN TEMPÉRATURE, COMMANDÉ PAR GRADIENT DE PRESSION

(30) Priorität: 21.10.2015 DE 102015220529
(43) Veröffentlichungstag der Anmeldung: 29.08.2018
(73) Patentinhaber: Lufthansa Technik AG, 22335 Hamburg (DE)
(72) Erfinder: BALKA, Matthias, 22393 Hamburg (DE)
(74) Vertreter: Müller Verweyen
(86) Internationale Anmeldenummer: PCT/EP2016/073328
(87) Internationale Veröffentlichungsnummer: WO 2017/067771

(56) Entgegenhaltungen:
- DE-A1- 2 443 991
- DE-A1- 10 352 308
- US-A- 2 493 351
- US-A- 3 180 956
- US-A- 3 735 376
- US-A- 3 946 175
- US-A- 5 578 993
- US-A1- 2010 211 031

## Beschreibung

Die vorliegende Erfindung betrifft ein Verfahren und eine korrespondierende Vorrichtung zum Testen eines temperaturkompensierten, druckgradientgesteuerten Druckschalters, der pneumatisch einem Primärdruckraum zugeordnet ist und zur Temperaturkompensation einen Sekundärdruckraum aufweist.

Aus dem Stand der Technik, beispielsweise aus der US 3,946,175 A, ist ein temperaturkompensierter, druckgradientgesteuerter Druckschalter bekannt. Solche Druckschalter werden in Druckbehältern eingesetzt, um den Auslöse- bzw. Schaltdruck möglichst nahe an dem aktuellen Betriebsdruck halten zu können. Werden Druckbehälter großen Temperaturschwankungen ausgesetzt, was beispielsweise bei Feuerlöschern in einem Luftfahrzeug der Fall sein kann, ändert sich der Betriebsdruck je nach Befüllung erheblich.

Bei einem solchen Druckschalter muss stets sichergestellt werden, dass dieser nicht unbeabsichtigt ausgelöst wird. Um dies bei nicht temperaturkompensierten Druckschaltern sicherzustellen, sind diese üblicherweise so ausgelegt, dass ein relativ großes Verhältnis zwischen Betriebsdruck und Auslösedruck vorgesehen ist; dieses Druckverhältnis liegt bei nicht temperaturkompensierten Druckschaltern üblicherweise zwischen 2 und 4. Liegt also beispielsweise der Betriebsdruck bei 8 bar, dann erfolgt bei einem Druckverhältnis von 4 ein Schalten des Druckschalters erst bei einem Druckabfall auf 2 bar.

Der aus der US 3,946,175 A bekannte Druckschalter mit Temperaturkompensation weist einen sogenannten Sekundärdruckraum auf, welcher mit den gleichen Inhaltsstoffen und Massenverhältnissen wie der Primärdruckraum befüllt ist, so dass das thermodynamische Verhalten des Primärdruckraums mit dem des Sekundärdruckraums mit Ausnahme des geringeren Volumens und der damit geringeren thermischen Kapazität identisch ist. Der Sekundärdruckraum ist von dem Primärdruckraum durch ein flexibles Trennelement hermetisch abgetrennt. Eine Druckdifferenz zwischen dem Primärdruckraum und dem Sekundärdruckraum kann so über das flexible Trennelement in eine translatorische Bewegung umgesetzt werden. Diese Bewegung wird dann auf einen Schlitten übertragen, welcher mit einem Magneten besetzt ist. Durch die Bewegung des Magneten kann dann ein Schaltmechanismus, in diesem Fall ein Reed-Schalter, betätigt werden.

Weiter ist in der US 3,946,175 A der Sekundärdruckraum thermisch an den Primärdruckraum gekoppelt, so dass sichergestellt werden kann, dass eine Temperaturschwankung im Primärdruckraum eine annähernd identische Druckveränderung in dem Primär- und Sekundärraum bewirkt. Das flexible Trennelement bleibt damit im Wesentlichen in seiner Ausgangsposition, so dass dadurch der Schlitten allenfalls geringfügig bewegt wird. Der durch den Magneten betätigbare Schaltmechanismus wird in diesem Zustand jedoch nicht ausgelöst.

Es kann somit von einem nahezu temperaturunabhängigen Druckschalter gesprochen werden, weshalb das Druckverhältnis zwischen Betriebsdruck und Auslösedruck üblicherweise bei Werten zwischen 1,3 und 1,6 liegt. Der Schaltmechanismus wird demzufolge bereits bei geringen Druckabfällen betätigt, wenn beispielsweise durch eine Leckage im Primärdruckbehälter ein Druckabfall verursacht wird. Ein Druckabfall in dem Primärdruckraum durch einen Temperaturabfall in der Umgebung löst den Schaltmechanismus hingegen nicht aus.

Solche temperaturkompensierten, druckgradientgesteuerten Druckschalter kommen beispielsweise in Feuerlöschern in Luftfahrzeugen zum Einsatz. Dabei muss in regelmäßigen Zeitabständen sichergestellt werden, dass der eingebaute Druckschalter noch funktionstüchtig ist.

Bei den bislang aus dem Stand der Technik bekannten Testverfahren war es erforderlich, zum Testen des Druckschalters den Primärdruckbehälter vollständig zu entleeren. Das Öffnen, Entleeren und Wiederbefüllen der Primärdruckbehälter ist jedoch arbeitsaufwändig und kostenintensiv. Weiter kann es bei diesem Verfahren zur Emission klimaschädlicher Gase kommen, welche durch das Be- und Entleervorgang sowie durch das Recycling der Inhaltsstoffe freigesetzt werden.

Schließlich hat solch ein Testverfahren den Nachteil, dass der Primärdruckbehälter durch das Auftrennen und anschließende Verschweißen beschädigt werden kann; ein solches Testverfahren kann auch nicht beliebig oft wiederholt werden, siehe BEATTIE, A.G. An Acoustic Emission Test for Aircraft Halon 1301 Fire Extinguisher Bottles, Federal Aviation Administration, Report No. DOT/FAA/AR-97/9, 1998.

Ferner ist aus der US 3,946,175 A ein Testverfahren bekannt, bei dem durch ein starkes externes Magnetfeld ein Schaltmechanismus, der in diesem Fall durch den Reed-Schalter gebildet ist, ausgelöst wird. Mit diesem Verfahren kann jedoch nur der elektronische Stromkreis getestet werden. Aussagen über den Auslösedruck und die mechanische Schaltfähigkeit des Druckschalters, also beispielsweise über die fehlerfreie Bewegungsfreiheit des Schlittens, können damit nicht getroffen werden. US 2,493,351 offenbart ein Verfahren zum Testen eines Thermostats für ein druckgesteuertes Feuermeldesystem nach dem Oberbegriff von Anspruch 1.

Es ist Aufgabe der Erfindung, ein Verfahren zum zuverlässigeren Testen der mechanischen und elektronischen Funktionsfähigkeit eines temperaturkompensierten, druckgradientgesteuerten Druckschalters bereitzustellen.

Die Aufgabe wird mit den Merkmalen der unabhängigen Ansprüche gelöst.

Gemäß dem Grundgedanken der Erfindung wird ein Verfahren zum Testen eines temperaturkompensierten, druckgradientgesteuerten Druckschalters, der pneumatisch einem Primärdruckraum zugeordnet ist und zur Temperaturkompensation einen Sekundärdruckraum aufweist, vorgeschlagen, wobei durch Verwendung wenigstens einer Temperiereinrichtung zwischen dem Primärdruckraum und dem Sekundärdruckraum ein Temperaturgradient eingestellt wird, der ausreichend groß ist, um zwischen dem Primärdruckraum und dem Sekundärdruckraum einen Druckgradienten zu erzeugen, welcher wenigstens dem Auslösedruckgradienten des Druckschalters entspricht.

Erfindungsgemäß wird durch die selektive Erwärmung und/oder Kühlung des Primär- und/oder Sekundärdruckraums erreicht, dass durch das Erzeugen eines Temperaturgradienten ein Auslösen des Druckschalters ermöglicht wird. Die Erfindung hat dabei erkannt, dass üblicherweise bereits Temperaturgradienten von ca. 30 K genügen, um bei gängigen temperaturkompensierten Druckschaltern einen Auslösedruck herbeizuführen. In Abhängigkeit der Inhaltsstoffe kann der Auslösedruck jedoch bereits bei kleineren oder auch erst bei größeren Druckgradienten erreicht werden. Der Auslösedruckgradient ist dabei der Relativdruck zwischen dem Primärdruckbehälter und einem Betriebsdruck, bei dem der Schaltmechanismus in dem Druckschalter den Schaltzustand wechselt.

Ferner kann der erforderliche Temperaturgradient durch das erfindungsgemäße Verfahren innerhalb einer relativ kurzen Zeit von ca. 30 Minuten erreicht werden und ein Auslösen des Schalters so vollständig ohne einen Eingriff in das System, d.h. ohne ein Entleeren und Wiederbefüllen des Primärdruckraums erreicht werden.

Weiter kann durch das Verfahren sowohl eine elektronische als auch eine mechanische Prüfung des Druckschalters vorgenommen werden. Vorzugsweise ist auch eine Steuer- und/oder Regelungseinrichtung vorgesehen, die bei Erreichen des Auslösedrucks automatisch die weitere Steigerung des Temperaturgradienten beendet, so dass ein unnötiges Kühlen und/oder Erwärmen vermieden werden kann. Das Verfahren ermöglicht damit ein effizientes, effektives und umweltfreundliches Testen temperaturkompensierter Druckschalter.

Es wird vorgeschlagen, dass der Sekundärdruckraum durch die erste Temperiereinrichtung erwärmt oder gekühlt wird. Vorzugsweise wird die Temperatur des Primärdruckraums, also des Raums, der mit einem Füllmedium befüllt ist, konstant gehalten. Der erforderliche Temperaturgradient wird damit vorzugsweise allein durch Kühlung oder Erwärmung des Sekundärdruckraums erreicht. Vorzugsweise wird der Sekundärdruckraum erwärmt, so dass das Füllmedium in dem Primärdruckraum infolge der Erwärmung des Sekundärdruckraums, insbesondere aufgrund der höheren Masse, deutlich langsamer und damit zeitverzögert erwärmt wird. Es stellt sich so durch Erwärmen des Sekundärdruckraums nach einer gewissen Zeit automatisch zwischen dem Primärdruckraum und Sekundärdruckraum der gewünschte Temperaturgradient ein.

Vorzugsweise wird ein aktives Kühl- oder Heizelement thermisch mit dem Primärdruckraum verbunden, so dass die thermischen Auswirkungen der ersten Temperiereinrichtung auf den Primärdruckraum zumindest teilweise kompensiert werden. Vorzugsweise ist das aktive Kühl- oder Heizelement unmittelbar an einer den Primärdruckraum bildenden Umwandung anliegend angeordnet. Vorzugsweise ist auch das aktive Kühl- oder Heizelement in räumlicher Nähe zu der ersten Temperiereinrichtung angeordnet, d.h. vorzugsweise weniger als die Hälfte der Entfernung des Druckschalters von dem am weitesten entfernten Punkt des Primärdruckraums, weiter vorzugsweise weniger als ein Drittel dieser Entfernung und insbesondere vorzugsweise weniger als ein Zehntel dieser Entfernung.

Ein aktives Kühl- oder Heizelement ist insbesondere dann vorteilhaft, wenn durch die thermische Isolationseinrichtung keine ausreichende Kompensation der Temperatureinwirkung der Temperiereinrichtung auf den Primärdruckraum möglich ist.

Weiter vorzugsweise wird der Primärdruckraum durch die zweite Temperiereinrichtung gekühlt oder erwärmt. Vorzugsweise wird durch die zweite Temperiereinrichtung eine Kühlung vorgenommen, wenn durch die erste Temperiereinrichtung eine Erwärmung des Sekundärdruckraums erfolgt und umgekehrt. Durch die Erwärmung, beispielsweise des Sekundärdruckraums und die Kühlung des Primärdruckraums, kann der erforderliche Temperaturgradient schneller erreicht werden. Vorzugsweise erfolgt die Erwärmung des Sekundärdruckraums durch die erste Temperiereinrichtung zeitgleich mit der Kühlung des Primärdruckraums durch die zweite Temperiereinrichtung.

Erfindungsgemäß wird der Primärdruckraum derart ausgerichtet, dass eine darin enthaltene Flüssigphase eines Füllmediums, die beispielsweise durch CBrF₃ gebildet wird, eine möglichst geringe Kontaktfläche zu dem Druckschalter aufweist, vorzugsweise besteht überhaupt keine Kontaktfläche. Dies kann beispielsweise dadurch erreicht werden, dass der Druckschalter während der Durchführung des Verfahrens in eine möglichst hoch gelegene Position gebracht wird. Die Erfindung hat erkannt, dass durch diese Ausrichtung die Gasphase, die den Druckschalter dann vorzugsweise weitestgehend oder vollständig umgibt, die Funktion eines isolierenden Mediums einnimmt. Die Wärmeübertragung von dem Druckschalter auf den Primärdruckraum kann somit verringert werden, so dass der Temperaturgradient insgesamt größer wird.

Weiter wird eine Testvorrichtung zum Testen eines temperaturkompensierten, druckgradientgesteuerten Druckschalters beschrieben, der pneumatisch einem Primärdruckraum zugeordnet ist und zur Temperaturkompensation einen Sekundärdruckraum aufweist, wobei eine Temperiereinrichtung vorgesehen ist, mittels derer ein Temperaturgradient zwischen dem Primärdruckraum und dem Sekundärdruckraum einstellbar ist, und der Druckschalter durch einen aufgrund des Temperaturgradienten verursachten Druckgradienten betätigbar ist. Erfindungsgemäß wird durch die Testvorrichtung ausgenutzt, dass der Auslösedruck auf einfache Art und Weise durch die Erzeugung eines Temperaturgradienten zwischen dem Primärdruckraum und dem Sekundärdruckraum erzeugt werden kann.

Vorzugsweise ist die Testvorrichtung dazu eingerichtet, eine Temperaturdifferenz von wenigstens 10 K zwischen dem Primärdruckraum und dem Sekundärdruckraum einzustellen, weiter vorzugsweise von wenigstens 20 K und insbesondere vorzugsweise von mehr als 30 K. Diese Temperaturgradienten sind erforderlich, um einen ausreichenden Druckgradienten aufzubauen, der dem Auslösedruck des Druckschalters entspricht.

Weiter vorzugsweise ist eine erste Temperiereinrichtung dazu eingerichtet, eine Umwandung des Sekundärdruckraums gezielt zu kühlen oder zu erhitzen. Vorzugsweise ist die Temperiereinrichtung flexibel und anpassungsfähig ausgeführt, so dass eine möglichst große Kontaktfläche zwischen der ersten Temperiereinrichtung und dem Druckschalter entsteht. Unter einer gezielten Erhitzung im Sinne dieser Erfindung ist zu verstehen, dass mehr als 50% der von der Temperiereinrichtung abgegebenen Wärmeenergie auf den Druckschalter übertragen werden kann, weiter vorzugsweise mehr als 70% und insbesondere vorzugsweise mehr als 90%. Vorzugsweise ist unter einer gezielten Erwärmung auch eine geometrische Anpassung der Temperiereinrichtung an die Geometrie des zu erwärmenden Gegenstandes zu verstehen. Entsprechend gilt dies auch für den Begriff der gezielten Kühlung, wobei dann gilt, dass wenigstens 50% der durch die Temperiereinrichtung aufgenommenen Wärmeenergie von dem zu kühlenden Gegenstand aufgenommen werden, weiter vorzugsweise mehr als 70% und insbesondere vorzugsweise mehr als 90%.

Bevorzugt ist die erste Temperiereinrichtung durch eine Silikonheizmatte gebildet, die vorzugsweise eine Leistung zwischen 10 und 30 W aufweist, weiter vorzugsweise weniger als 20 W. Durch die flexible Ausführung der Temperiereinrichtung wird eine bestmögliche Wärmeübertragung von der ersten Temperiereinrichtung über die den Sekundärdruckraum bildende Umwandung bis in den eigentlichen Sekundärdruckraum ermöglicht. Dadurch, dass der Druckschalter üblicherweise größtenteils in den Primärdruckraum hineinragt, ist dieser nur begrenzt zugänglich. Vorzugsweise ist die erste Temperiereinrichtung deshalb dazu eingerichtet, an dem außerhalb des Primärdruckraums liegenden Teil des Druckschalters befestigt zu werden. Bevorzugt erfolgt die Befestigung der Temperiereinrichtung an dem Druckschalter über ein Befestigungselement, wie zum Beispiel über ein Spannelement, eine Klemme oder eine Schraubschelle.

Es wird weiter vorgeschlagen, dass eine zweite Temperiereinrichtung dazu eingerichtet ist, eine Umwandung des Primärdruckraums gezielt zu kühlen oder zu erhitzen. Da vorzugsweise die erste Temperiereinrichtung dazu eingerichtet ist, den Sekundärdruckraum zu erwärmen, ist vorzugsweise die zweite Temperiereinrichtung dazu eingerichtet, den Primärdruckraum zu kühlen. Es hat sich dabei als vorteilhaft erwiesen, wenn die zweite Temperiereinrichtung mit der Umwandung des Primärdruckraums eine Kontaktfläche bildet. Vorteilhafterweise ist die Kontaktfläche an der der ersten Temperiereinrichtung gegenüberliegenden Seite des Primärdruckraums angeordnet. Die wärmende erste Temperiereinrichtung ist damit möglichst weit von der kühlenden zweiten Temperiereinrichtung entfernt angeordnet. Weiter vorzugsweise ist die zweite Temperiereinrichtung derart angeordnet, dass die Flüssigphase eines Füllmediums innerhalb des Primärdruckraums die Fläche an der Innenseite der Umwandung bedeckt, die der zweiten Temperiereinrichtung unmittelbar gegenüberliegt. Es wird so gewährleistet, dass von der zweiten Temperiereinrichtung eine Wärmeübertragung über die Umwandung auf die Flüssigphase des Füllmediums stattfindet, wodurch eine effizientere Kühlung des Primärdruckraums erfolgen kann.

Weiter wird eine thermische Isolationseinrichtung vorgeschlagen, die die Außenfläche der Umwandung umgibt. Das ist insbesondere dann vorteilhaft, wenn eine zweite Temperiereinrichtung nur einen Teil der Umwandung gibt und damit die übrige Umwandung durch die Umgebungswärme erwärmt wird. Durch die Isolationswirkung kann dieser negative Effekt verhindert werden.

Schließlich ist eine erste Sensoreinrichtung zur Bestimmung der Temperatur einer Umwandung des Sekundärdruckraums und/oder eine zweite Sensoreinrichtung zur Bestimmung der Temperatur einer Umwandung des Primärdruckraums vorgesehen. Die Temperatursensoren können dazu genutzt werden, Eingangsdaten für eine Steuer- oder Regelungseinrichtung zu bilden. So kann beispielsweise die Kühl- und/oder Heizleistung verringert werden, wenn eine zu hohe oder zu geringe Temperatur detektiert wird.

Es ist vorteilhaft, wenn eine Detektionseinrichtung zum Bestimmen des Füllstands des Primärdruckraums vorgesehen ist. Vorzugsweise kann die Detektionseinrichtung durch ein Ultraschallmessgerät oder durch eine Massenbestimmungseinrichtung gebildet sein. Die Kenntnis des Füllstandes innerhalb des Primärdruckraums zusammen mit den Temperaturdaten an unterschiedlichen Stellen des Primärdruckbehälters ermöglicht es, basierend auf einem thermodynamischen Fluidmodell die Temperaturverteilung innerhalb des Primärdruckbehälters zu berechnen. Anhand dieser Temperaturverteilung kann wiederum ein Druckverhältnis berechnet werden, das einen Rückschluss über den genauen Auslösedruckgradienten des Druckschalters ermöglicht.

Weiter ist es vorteilhaft, wenn eine Durchgangsprüfeinrichtung zum Ermitteln des Schaltzustands des Druckschalters vorgesehen ist. Als Durchgangsprüfeinrichtung kann beispielsweise ein Multimeter genutzt werden, dass über eine elektronische Leitung mit dem eigentlichen Schaltmechanismus des Druckschalters verbunden ist. Wird dieser Schalter geöffnet oder geschlossen, kann dies von der Durchgangsprüfeinrichtung detektiert werden. Vorzugsweise ist die Durchgangsprüfeinrichtung mit der Steuer- oder Regelungseinrichtung signaltechnisch verbunden, so dass in Abhängigkeit der Schaltstellung Einfluss auf den Testvorgang genommen werden kann. So kann beispielsweise eine Erhitzung des Sekundärdruckraums nur so lange erfolgen, bis von der Durchgangsprüfeinrichtung detektiert wird, dass sich der Schaltzustand geändert hat. Eine unnötige thermische Belastung wird so vermieden.

Die Erfindung wird im Folgenden anhand bevorzugter Ausführungsformen unter Bezugnahme auf die beigefügten Figuren erläutert. Dabei zeigt
- Fig. 1: eine erste Ausführungsform einer erfindungsgemäßen Testvorrichtung, bei der die zweite Temperiereinrichtung durch eine Thermokammer gebildet ist; und
- Fig. 2: eine zweite Ausführungsform einer erfindungsgemäßen Testvorrichtung, bei der die zweite Temperiereinrichtung durch ein flächiges Kühlelement gebildet ist.

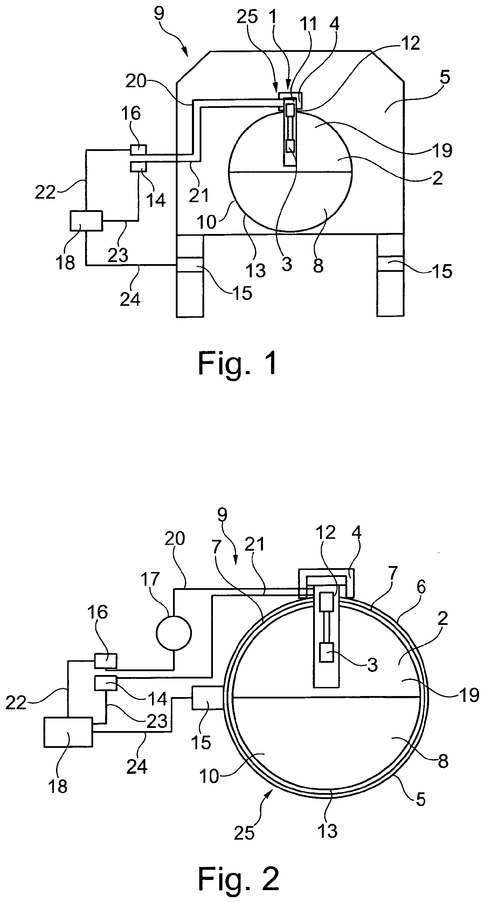

Fig. 1 zeigt eine erste Ausführungsform einer erfindungsgemäßen Testvorrichtung 9, die im Wesentlichen durch einen Druckbehälter 25, eine erste Temperiereinrichtung 4 sowie eine zweite Temperiereinrichtung 5 gebildet ist.

Der Druckbehälter 25 kann beispielsweise durch einen Feuerlöscher gebildet sein, wobei durch eine Umwandung 10 ein Primärdruckraum 2 gebildet wird. Ferner umfasst der Druckbehälter 25 einen temperaturkompensierten, druckgradientgesteuerten Druckschalter 1, der einen Sekundärdruckraum 3 aufweist. Der Druckschalter 1 ist über einen Flansch mit der Umwandung 10 verbunden. Der Druckschalter 1 weist ferner einen Schaltmechanismus auf, dessen Schaltzustand sich bei Überschreiten eines vordefinierten Druckverhältnisses zwischen dem Druck im Primärdruckraum 2 und einem Betriebsdruck ändert.

Die Temperaturkompensation des Druckschalters 1 erfolgt dadurch, dass der Sekundärdruckraum 3 thermisch mit dem Primärdruckraum 2 in Wirkverbindung steht. Demzufolge sinkt bei einem Temperaturabfall in dem Primärdruckraum 2 auch die Temperatur in dem Sekundärdruckraum 3, weshalb es in beiden Druckräumen 2 und 3 durch die Befüllung mit einem identischen Füllmedium 8 und 19 ebenfalls zu einem entsprechenden Druckabfall kommt. Somit bewirkt ein temperaturinduzierter Temperaturabfall in dem Primärdruckraum 2 keinen Wechsel des Schaltzustands des Schaltmechanismus; der Druckschalter 1 ist somit temperaturkompensiert.

Der Grundgedanke der vorliegenden Erfindung besteht darin, dass durch selektives Kühlen bzw. Erwärmen des Primärdruckraums 2 und/oder des Sekundärdruckraum 3 ein Temperaturgradient zwischen dem Primärdruckraum 2 und dem Sekundärdruckraum 3 entsteht, der wiederum einen Druckgradienten zwischen dem Primärdruckraum 2 und dem Sekundärdruckraum 3 bewirkt. Der mit der Testvorrichtung 9 hergestellte Druckgradient muss dabei das den Schaltmechanismus auslösende Druckverhältnis überschreiten.

In dem Ausführungsbeispiel aus Fig. 1 wird die Temperaturdifferenz durch die erste Temperiereinrichtung 4 hergestellt. Vorzugsweise handelt es sich dabei um eine wärmende Temperiereinrichtung 4, die weiter vorzugsweise durch eine Silikonheizmatte gebildet ist. Die erste Temperiereinrichtung 4 kann vorzugsweise auch durch einen Wärmespeicher, durch ein beliebig anderes elektrisches Heizelement, durch ein mit Wärmemittel durchströmtes Heizelement oder durch ein strahlendes Heizelement gebildet sein. Vorzugsweise hat die erste Temperiereinrichtung 4 eine Heiz- oder Kühlleistung zwischen 10 und 60 W, weiter vorzugsweise zwischen 15 und 25 W.

Der Druckschalter 1 ragt größtenteils in den Primärdruckraum 2 hinein, so dass die erste Temperiereinrichtung 4 so ausgeführt sein muss, dass eine bestmögliche Wärmeübertragung an dem von außen zugänglichen Teil des Druckschalters 1 möglich ist. Die erste Temperiereinrichtung 4 ist deshalb vorzugsweise dazu eingerichtet, thermisch mit dem außerhalb des Primärdruckraums 2 liegenden Teil des Druckschalters 1, also einem Druckschaltergehäuse 11, zusammenzuwirken. Vorzugsweise bildet das Druckschaltergehäuse 11 die Umwandung 11 des Sekundärdruckraums 3.

Über das Druckschaltergehäuse 11 wird die Wärmeenergie auf den Sekundärdruckraum 3 und das darin enthaltene Füllmedium 19 übertragen. Aufgrund der thermischen Trägheit des ersten Primärdruckraums 2 wird durch die erste Temperiereinrichtung 4 nur in einem wesentlich geringeren Maße eine Erwärmung des Primärdruckraums 2 im Vergleich zum Sekundärdruckraum 3 erreicht. Es kann damit eine Temperaturdifferenz zwischen dem Primär- und dem Sekundärdruckraum 2 und 3 eingestellt werden, wodurch auch ein Druckgradient zwischen den beiden Druckräumen 2 und 3 entsteht.

In dem in Fig. 1 gezeigten Ausführungsbeispiel ist neben der ersten Temperiereinrichtung 4 die zweite Temperiereinrichtung 5 vorgesehen, die hier vorzugsweise durch eine Thermokammer gebildet ist. Es handelt sich dabei vorzugsweise um eine kühlende Thermokammer, die dazu eingerichtet ist, den gesamten Druckbehälter 25 aufzunehmen. Die zweite Temperiereinrichtung 5 kühlt in diesem Fall nahezu vollständig die Umwandung 10 des Primärdruckraums 2, so dass dadurch auch das Füllmedium 8, 19 gekühlt wird. Demzufolge kann durch die zweite Temperiereinrichtung 5 eine weitere Erhöhung des Temperaturgradienten erfolgen bzw. ein Temperaturgradient eingestellt werden, der allein durch die erste Temperiereinrichtung 4 nicht einstellbar wäre.

Vorzugsweise ist der Druckbehälter 25 derart ausgerichtet, dass der Druckschalter 1 möglichst an der höchstmöglich gelegenen Stelle angeordnet ist. Handelt es sich um einen kugelförmigen Primärdruckraum 2, so ist der Druckbehälter 25 vorzugsweise so ausgerichtet, dass der Druckschalter 1 den obersten Pol bildet. Wie in Fig. 1 zu erkennen ist, kann durch diese Ausrichtung des Druckbehälters 25 der Druckschalter 1 vollständig von der Gasphase 19 des Füllmediums umgeben werden, d.h. die Flüssigphase 8 des Füllmediums hat keinen Kontakt zu dem Druckschalter 1. Dadurch, dass die Gasphase 19 keinen Kontakt zu dem Druckschalter 1 hat, wirkt diese thermisch isolierend, so dass die von der ersten Temperiereinrichtung 4 an den Druckschalter 1 abgegebene Wärmeenergie nur zu einem sehr geringen Anteil auf das Füllmedium 8 und 19 übertragen wird. So kann die auf den Druckschalter 1 übertragene Wärmeenergie größtenteils zur Erwärmung des Sekundärdruckraums 3 genutzt werden, wodurch insgesamt ein größerer Temperaturgradient zwischen dem Primärdruckraum 2 und dem Sekundärdruckraum 3 entsteht.

Schließlich ist die Ausrichtung des Druckbehälters 25 in der zuvor beschriebenen Art und Weise auch dann zweckmäßig, wenn der Primärdruckraum 2 so weit befüllt ist, dass unabhängig von der Ausrichtung des Druckbehälters 25 die Flüssigphase 8 des Füllmediums den Druckschalter 1 berührt, denn auch dann wird die Kontaktfläche zwischen dem Druckschalter 1 und der Flüssigphase 8 des Füllmediums verringert und damit auch die Wärmeübertragung auf ein Minimum reduziert.

Ferner ist in dem ersten Ausführungsbeispiel aus Fig. 1 eine erste Sensoreinrichtung 12 vorgesehen, die vorzugsweise an einer Kontaktstelle zwischen der ersten Temperiereinrichtung 4 und dem Druckschalter 1 angeordnet ist. Weiter vorzugsweise ist die Sensoreinrichtung auch an dem Flansch des Druckschalters 1 angeordnet, der zur Befestigung des Druckschalters 1 an der Umwandung 10 dient.

Für den Fall, dass eine erste Temperiereinrichtung 4 durch eine Silikonheizmatte gebildet ist, kann die erste Sensoreinrichtung 12 vorzugsweise in die Silikonheizmatte integriert sein. Durch die erste Sensoreinrichtung 12, die vorzugsweise durch eine Temperaturmesseinrichtung, z.B. durch einen PT100-Sensor, gebildet ist, kann die Oberflächentemperatur des Druckschaltergehäuses 11 überwacht werden und somit eine thermische Überbeanspruchung des Druckschalters 1 vermieden werden.

Alternativ oder zusätzlich kann auch eine zweite Sensoreinrichtung 13 zur Überwachung der Temperatur des Primärdruckraums 2 vorgesehen sein. Vorzugsweise ist die zweite Sensoreinrichtung 13 an der Umwandung 10 des Primärdruckraums 2 angeordnet, weiter vorzugsweise an einer dem Druckschalter 1 gegenüberliegenden Stelle des Primärdruckraums 2. Über die beiden Messpunkte der ersten und zweiten Sensoreinrichtung 12 und 13 kann näherungsweise der Temperaturgradient und damit auch der Druckgradient zwischen dem Primärdruckraum 2 und dem Sekundärdruckraum 3 ermittelt werden.

Weiterhin kann eine Detektionseinrichtung 15 zur Bestimmung der Massen und/oder Volumina der Flüssig- und Gasphase 8 und 19 des Füllmediums vorgesehen sein. Die durch die Detektionseinrichtung 15 ermittelten Werte können zusammen mit einem thermodynamischen Fluidmodell dazu genutzt werden, den Nominalzustand des Primär- und Sekundärdruckraums 2 und 3 zu berechnen. Es können so genauere Aussagen über die thermodynamischen Bedingungen zum Auslösezeitpunkt des Schaltmechanismus getroffen werden, wodurch die Funktionstüchtigkeit des Druckschalters 1 insgesamt zuverlässiger beurteilt werden kann. In diesem Ausführungsbeispiel wird die Detektionseinrichtung 15 vorzugsweise durch eine Massenermittlungseinrichtung gebildet, die in Fig. 1 nur schematisch dargestellt ist. Eine beliebige andere Anordnung der Detektionseinrichtung 15 ist ebenfalls denkbar.

Weiter ist eine Heizungssteuerung 16 vorgesehen, die über eine Anschlussleitung 20 mit der ersten Temperiereinrichtung 4 verbunden ist. Die Heizungssteuerung 16 dient damit zur Einstellung der Heizleistung.

Weiter ist vorzugsweise eine Durchgangsprüfeinrichtung 14 vorgesehen, die über eine Anschlussleitung 21 mit dem Druckschalter 1 elektrisch verbunden ist und detektieren kann, in welchem Schaltzustand sich der Schaltmechanismus befindet. Vorzugsweise ist die Durchgangsprüfeinrichtung 14 durch ein Multimeter gebildet.

Bevorzugt ist zusätzlich eine Steuer- oder Regelungseinrichtung 18 vorgesehen, die signaltechnisch vorzugsweise über Anschlussleitungen 22, 23 und 24 mit der Heizungssteuerung 16, der Durchgangsprüfeinrichtung 14 und/oder mit der Detektionseinrichtung 15 verbunden ist. Die Steuer- oder Regelungseinrichtung 18 ist dabei vorzugsweise dazu eingerichtet, den Testablauf automatisiert durchzuführen. Die Steuer- oder Regelungseinrichtung 18 kann beispielsweise an die Heizungssteuerung 16 das Signal geben, die erste Temperiereinrichtung 4 für einen Heizvorgang zu aktivieren. Dies geschieht vorzugsweise so lange, bis die Durchgangsprüfeinrichtung 14 einen Schaltzustandswechsel des Schaltmechanismus detektiert und diese Information über die Anschlussleitung 23 der Steuer- oder Regelungseinrichtung 18 zur Verfügung gestellt wird. Das weitere Erwärmen durch die erste Temperiereinrichtung 4 wird demzufolge gestoppt, so dass eine Abkühlung des Sekundärdruckraums 3 stattfindet und in Folge einer Angleichung der Temperaturen in dem Primär- und Sekundärdruckraum 2 und 3 der ursprüngliche Schaltzustand des Schaltmechanismus wieder hergestellt wird. Es lässt sich somit auch eine Schalthysterese des Schaltmechanismus bestimmen, d.h. zu welchem Zeitpunkt bzw. bei welchem Druckgradienten der Schaltmechanismus von einem ersten Schaltzustand in einen zweiten Schaltzustand und zurück geschaltet wird.

Vorzugsweise kann auch die erste und/oder zweite Sensoreinrichtung 12 und/oder 13 mit der Steuer- oder Regelungseinrichtung 18 signaltechnisch verbunden sein. Es kann so während des gesamten Testablaufs eine Temperaturüberwachung zur Vermeidung von thermischer Überbelastung an dem Druckbehälter 25 vorgenommen werden.

Vorzugsweise können auch die Informationen der Detektionseinrichtung 15 verarbeitet werden, beispielsweise um in Kombination mit den Temperaturwerten der ersten und zweiten Sensoreinrichtung 12 und 13 genauere Aussagen über die thermodynamischen Bedingungen während der Wechsel der Schaltzustände zu erhalten. Diese Werte können beispielsweise auf einem Datenträger oder einem anderen Speichermedium jeweils spezifisch für den zu testenden Druckbehälter 25 gespeichert werden, so dass auch eine Archivierung der Testergebnisse möglich ist.

Wird auf eine Steuer- oder Regelungseinrichtung 18 verzichtet, kann das Deaktivieren der ersten und/oder zweiten Temperiereinrichtung 4 und/oder 5 auch händisch oder automatisch nach Ablauf einer voreingestellten Zeit erfolgen.

Die in Fig. 1 gezeigte Steuer- oder Regelungseinrichtung 18 kann alternativ auch die Funktion der Heizungssteuerung 16 und/oder der Durchgangsprüfeinrichtung 14 mitübernehmen.

Fig. 2 zeigt eine zweite Ausführungsform der Erfindung, die einen ähnlichen Aufbau aufweist wie die erste Ausführungsform aus Fig. 1. Der wesentliche Unterschied zwischen diesen Ausführungsformen besteht darin, dass die zweite Temperiereinrichtung 5 nicht durch eine Thermokammer gebildet ist, sondern vorzugsweise durch ein unmittelbar an der Umwandung 10 des Primärdruckraums 2 anliegendes Kühlelement.

Vorzugsweise handelt es sich dabei um ein flächiges, der Kontur der Umwandung 10 angepasstes oder anpassungsfähiges Kühlelement mit einem hohen Wärmeleitkoeffizienten, beispielsweise aus Kupfer. Es besteht alternativ auch die Möglichkeit einer direkten Flüssigkeitskühlung über einen Kühlkreislauf oder die Direktkühlung durch Flüssigstickstoff.

Die Kontaktfläche zwischen der zweiten Temperiereinrichtung 5 und der Umwandung 10 kann in Abhängigkeit des erforderlichen Temperaturgradienten unterschiedlich groß sein. So kann bei einer kugelförmigen Geometrie des Druckbehälters beispielsweise nur der untere Pol, die untere Hälfte oder die gesamte Umwandung 10 gekühlt werden. Die thermische Leitfähigkeit kann vorzugsweise über eine Wärmeleitmasse verbessert werden, was auch für die Kontaktfläche zwischen der ersten Temperiereinrichtung 4 und dem Druckschalter 1 gilt.

Ferner ist Fig. 2 zu entnehmen, dass der Teil der Umwandung 10, der nicht von der zweiten Temperiereinrichtung 5 umgeben ist, vorzugsweise von einer thermischen Isolationseinrichtung 6 umgeben ist. Es kann so verhindert werden, dass die durch die zweite Temperiereinrichtung 5 erfolgte Kühlung des Primärdruckraums 2 durch eine Aufnahme der Umgebungswärmeenergie über die Umwandung 10 verringert wird. Bevorzugt kann die thermische Isolationseinrichtung 6 zusätzlich auch den aus dem Primärdruckraum 2 herausragenden Teil des Druckschalter 1 umgeben.

Schließlich kann auch ein aktives Kühl- oder Heizelement 7 vorgesehen sein, das dazu eingerichtet ist, die ungewünschte thermische Wirkung der ersten Temperiereinrichtung 4 auf den Primärdruckraum 2 zu verringern oder zu kompensieren. Ist die erste Temperiereinrichtung 4 als Wärmeelement ausgeführt, dann ist das aktive Kühl- oder Heizelement 7 als Kühlelement ausgeführt und umgekehrt. Das Kühlelement ist vorzugsweise flüssigkeitsgekühlt.

Für eine bestmögliche Wirkung ist das aktive Kühl- oder Heizelement 7 möglichst nahe an der ersten Temperiereinrichtung 4 angeordnet, d.h. in einem Abstand von weniger als 100 mm zu dem Flansch des Druckschalters 1, weiter vorzugsweise weniger als 50 mm und weiter vorzugsweise weniger als 20 mm.

Weiterhin hat es sich als vorteilhaft erwiesen, wenn das aktive Kühl- oder Heizelement 7 die erste Temperiereinrichtung 4 ringförmig umgibt, so dass eine ungehinderte Wärmeübertragung in den entfernten bzw. unteren Bereich der Umwandung 10 des Primärdruckraums 2 verhindert werden kann.

Es hat sich in der Praxis gezeigt, dass durch die Kombination der thermischen Isolationseinrichtung 6 in Kombination mit dem aktiven Kühlelement 7 eine thermische Entkoppelung der durch die erste Temperiereinrichtung 4 bewirkten Erwärmung von der durch die zweite Temperiereinrichtung 5 eingebrachten Abkühlung erzielt werden kann, was eine höhere Leistungsfähigkeit der Testvorrichtung 9 im Sinne eins größeren Temperaturgradienten bewirkt.

Ein weiterer Unterschied im Vergleich zu der ersten Ausführungsform in Fig. 1 besteht darin, dass eine Leistungsmesseinrichtung 17 vorgesehen ist, die dazu dient, die Heiz- oder Kühlleistung vorzugsweise der ersten Temperiereinrichtung 4 zu überwachen. Alternativ oder zusätzlich kann die Leistungsmesseinrichtung 17 auch der zweiten Temperiereinrichtung 5 zugeordnet sein.

Schließlich besteht auch ein Unterschied in der Detektionseinrichtung 15, die in dem zweiten Ausführungsbeispiel durch eine Ultraschallmesseinrichtung gebildet ist.

Zu dem Offenbarungsgehalt dieser Anmeldung sind beliebige Kombinationen der in den Fig. 1 und Fig. 2 gezeigten Ausführungsformen hinzuzuzählen.

Der Offenbarungsgehalt dieser Anmeldung ist ferner nicht auf die in den vorangehenden Ausführungsbeispielen der Fig. 1 und Fig. 2 beschriebenen Ausführungsformen, bei der die erste Temperiereinrichtung 4 als Heizelement und die zweite Temperiereinrichtung 5 als Kühlelement eingerichtet ist, beschränkt. Die Erzeugung eines Temperaturgradienten auf umgekehrte Art und Weise, also dadurch, dass die erste Temperiereinrichtung 4 ein Kühlelement und die zweite Temperiereinrichtung 5 ein Wärmeelement ist, ist ebenfalls möglich.

Ferner sind ausdrücklich zu dem Offenbarungsgehalt dieser Anmeldung Abwandlungen der in den Fig. 1 und Fig. 2 gezeigten Ausführungsformen hinzuzuzählen, bei denen nur eine erste oder nur eine zweite Temperiereinrichtung 4 oder 5 vorgesehen ist.

## Patentansprüche

1. Verfahren zum Testen eines temperaturkompensierten, druckgradientgesteuerten Druckschalters (1), der pneumatisch einem Primärdruckraum (2) zugeordnet ist und zur Temperaturkompensation einen Sekundärdruckraum (3) aufweist, wobei durch Verwendung wenigstens einer Temperiereinrichtung (4, 5) zwischen dem Primärdruckraum (2) und dem Sekundärdruckraum (3) ein Temperaturgradient eingestellt wird, der ausreichend groß ist, um zwischen dem Primärdruckraum (2) und dem Sekundärdruckraum (3) einen Druckgradienten zu erzeugen, welcher wenigstens dem Auslösedruckgradienten des Druckschalters (1) entspricht, **dadurch gekennzeichnet, dass**
der Primärdruckraum (2) derart ausgerichtet wird, dass eine darin enthaltene Flüssigphase eines Füllmediums (8) eine möglichst geringe Kontaktfläche zu dem Druckschalter (1) aufweist.

2. Verfahren nach Anspruch 1, **dadurch gekennzeichnet, dass**
der Sekundärdruckraum (3) durch die erste Temperiereinrichtung (4) erwärmt oder gekühlt wird.

3. Verfahren nach Anspruch 2, **dadurch gekennzeichnet, dass**
ein aktives Kühl- oder Heizelement (7) thermisch mit dem Primärdruckraum (2) verbunden wird, so dass die thermischen Auswirkungen der ersten Temperiereinrichtung (4) auf den Primärdruckraum (2) zumindest teilweise kompensiert werden.

4. Verfahren nach einem der vorangehenden Ansprüche, **dadurch gekennzeichnet, dass** der Primärdruckraum (2) durch die zweite Temperiereinrichtung (5) gekühlt oder erwärmt wird.

5. Verfahren nach Anspruch 4 unter Rückbezug auf einen der Ansprüche 2 bis 3,
**dadurch gekennzeichnet, dass**
der Sekundärdruckraum (3) durch die erste Temperiereinrichtung (4) erwärmt und gleichzeitig der Primärdruckraum (2) durch die zweite Temperiereinrichtung (5) gekühlt wird.

6. Verfahren nach einem der vorangehenden Ansprüche, **dadurch gekennzeichnet, dass** mittels einer Testvorrichtung (9) eine Temperaturdifferenz von wenigstens 10 K zwischen dem Primärdruckraum (2) und dem Sekundärdruckraum (3) eingestellt wird.

7. Verfahren nach einem der vorangehenden Ansprüche, **dadurch gekennzeichnet, dass** mittels einer ersten Temperiereinrichtung (4) eine Umwandung (11) des Sekundärdruckraums (3) gezielt gekühlt oder erhitzt wird.

8. Verfahren nach Anspruch 7, **dadurch gekennzeichnet, dass**
die erste Temperiereinrichtung (4) durch eine Silikonheizmatte gebildet ist.

9. Verfahren nach einem der vorangehenden Ansprüche, **dadurch gekennzeichnet, dass** mittels einer zweiten Temperiereinrichtung (5) eine Umwandung (10) des Primärdruckraums (2) gezielt gekühlt oder erhitzt wird.

10. Verfahren nach Anspruch 9, **dadurch gekennzeichnet, dass** die Außenfläche der Umwandung (10) des Primärdruckraumes (2) von einer thermischen Isolationseinrichtung (6) umgeben wird.

11. Verfahren nach einem der vorangehenden Ansprüche 9 und 10, **dadurch gekennzeichnet, dass** mittels einer ersten Sensoreinrichtung (12) die Temperatur einer Umwandung (11) des Sekundärdruckraums (3) und/oder mittels einer zweiten Sensoreinrichtung (13) die Temperatur einer Umwandung (10) des Primärdruckraums (2) bestimmt wird.

12. Verfahren nach einem der vorangehenden Ansprüche **dadurch gekennzeichnet, dass** mittels einer Durchgangsprüfeinrichtung (14) der Schaltzustand des Druckschalters (1) ermittelt wird.

## Claims

1. Method for testing a temperature-compensated, pressure-gradient-controlled pressure switch (1), which is pneumatically associated with a primary pressure chamber (2) and comprises a secondary pressure chamber (3) for temperature compensation,
wherein by using at least one temperature-control apparatus (4, 5) between the primary pressure chamber (2) and the secondary pressure chamber (3), a temperature gradient is set which is sufficiently great to produce a pressure gradient between the primary pressure chamber (2) and the secondary pressure chamber (3) that corresponds at least to the triggering pressure gradient of the pressure switch (1), **characterised in that**,
the primary pressure chamber (2) is oriented such that a liquid phase of a filling medium (8) contained therein has as small as possible a contact surface with the pressure switch (1).

2. Method according to claim 1, **characterised in that** the secondary pressure chamber (3) is heated or cooled by the first temperature-control apparatus (4).

3. Method according to claim 2, **characterised in that** an active cooling or heating element (7) is thermally connected to the primary pressure chamber (2) such that the thermal effects of the first temperature-control apparatus (4) on the primary pressure chamber (2) are compensated for at least in part.

4. Method according to any of the preceding claims, **characterised in that** the primary pressure chamber (2) is cooled or heated by the second temperature-control apparatus (5).

5. Method according to claim 4 with reference to any of claims 2 to 3, **characterised in that** the secondary pressure chamber (3) is heated by the first temperature-control apparatus (4) and the primary pressure chamber (2) is simultaneously cooled by the second temperature-control apparatus (5).

6. Method according to any of the preceding claims, **characterised in that** a temperature difference of at least 10 K between the primary pressure chamber (2) and the secondary pressure chamber (3) is set by means of a test device (9).

7. Method according to any of the preceding claims, **characterised in that** a surrounding wall (11) of the secondary pressure chamber (3) is cooled or heated in a targeted manner by means of a first temperature-control apparatus (4).

8. Method according to claim 7, **characterised in that** the first temperature-control apparatus (4) is formed by a silicone heating mat.

9. Method according to any of the preceding claims, **characterised in that** a surrounding wall (10) of the primary pressure chamber (2) is cooled or heated in a targeted manner by means of a second temperature-control apparatus (5).

10. Method according to claim 9, **characterised in that** the outer surface of the surrounding wall (10) is surrounded by a thermal insulation apparatus (6).

11. Method according any of the preceding claims 9 and 10, **characterised in that** by means of a first sensor apparatus (12) the temperature of a surrounding wall (11) of the secondary pressure chamber (3) and/or by means of a second sensor apparatus (13) the temperature of a surrounding wall (10) of the primary pressure chamber (2) is determined.

12. Method according to any of the preceding claims, **characterised in that** the switching state of the pressure switch (1) is determined by means of a continuity tester (14).

## Revendications

1. Procédé pour tester un pressostat (1) compensé en température, commandé par gradient de pression, qui est associé de manière pneumatique à une chambre de pression primaire (2) et qui comporte, pour la compensation de température, une chambre de pression secondaire (3), un gradient de température entre la chambre de pression primaire (2) et la chambre de pression secondaire (3) étant réglé en utilisant au moins un moyen d'équilibrage de température (4, 5), ledit gradient de température étant suffisamment élevé pour générer un gradient de pression entre la chambre de pression primaire (2) et la chambre de pression secondaire (3), lequel correspond au moins au gradient de pression de déclenchement du pressostat (1), **caractérisé en ce que** la chambre de pression primaire (2) est orientée de telle manière qu'une phase liquide d'un milieu de remplissage (8) contenue dans celle-ci présente une surface de contact la plus petite possible avec le pressostat (1).

2. Procédé selon la revendication 1, **caractérisé en ce**
**que** la chambre de pression secondaire (3) est chauffée ou refroidie par le premier moyen d'équilibrage de température (4).

3. Procédé selon la revendication 2, **caractérisé en ce**
**qu'**un élément de refroidissement ou de chauffage (7) actif est relié de manière thermique à la chambre de pression primaire (2), de telle sorte que les effets thermiques du premier moyen d'équilibrage de température (4) sur la chambre de pression primaire (2) sont au moins en partie compensés.

4. Procédé selon l'une des revendications précédentes, **caractérisé en ce**
**que** la chambre de pression primaire (2) est refroidie ou chauffée par le second moyen d'équilibrage de température (5).

5. Procédé selon la revendication 4, en référence à l'une des revendications 2 à 3, **caractérisé en ce**
**que** la chambre de pression secondaire (3) est chauffée par le premier moyen d'équilibrage de température (4) et, simultanément, la chambre de pression primaire (2) est refroidie par le second moyen d'équilibrage de température (5).

6. Procédé selon l'une des revendications précédentes, **caractérisé en ce**
**qu'**une différence de température d'au moins 10 K entre la chambre de pression primaire (2) et la chambre de pression secondaire (3) est réglée au moyen d'un dispositif de test (9).

7. Procédé selon l'une des revendications précédentes, **caractérisé en ce**
**qu'**une paroi (11) de la chambre de pression secondaire (3) est refroidie ou chauffée de manière ciblée au moyen d'un premier moyen d'équilibrage de température (4).

8. Procédé selon la revendication 7, **caractérisé en ce**
**que** le premier moyen d'équilibrage de température (4) est formé par un tapis chauffant en silicone.

9. Procédé selon l'une des revendications précédentes, **caractérisé en ce**
**qu'**une paroi (10) de la chambre de pression primaire (2) est refroidie ou chauffée de manière ciblée au moyen d'un second moyen d'équilibrage de température (5).

10. Procédé selon la revendication 9,
**caractérisé en ce**
**que** la surface extérieure de la paroi (10) de la chambre de pression primaire (2) est entourée d'un moyen d'isolation thermique (6).

11. Procédé selon l'une des revendications précédentes 9 et 10, **caractérisé en ce**
**que** la température d'une paroi (11) de la chambre de pression secondaire (3) est déterminée au moyen d'un premier moyen de détection (12) et/ou la température d'une paroi (10) de la chambre de pression primaire (2) est déterminée au moyen d'un second moyen de détection (13).

12. Procédé selon l'une des revendications précédentes, **caractérisé en ce**
**que** l'état de commutation du pressostat (1) est déterminé au moyen d'un moyen de contrôle de continuité (14).
